# EUROPÄISCHE PATENTANMELDUNG

(11) **EP 1 480 501 A1**
(43) Veröffentlichungstag der Anmeldung: **24.11.2004**
(21) Anmeldenummer: 03011383.1
(22) Anmeldetag: 19.05.2003
(51) Int. Cl.: H05K 5/00, H05K 7/14, H04M 1/02, H04M 11/02

(54) **Türstation einer Hauskommunikationsanlage sowie Funktionseinheit einer solchen Türstation**

(71) Anmelder: Bitron Video S.r.l., 10044 Pianezza (TO) (IT)
(72) Erfinder: Bersano, Marco, 10044 Pianezza (TO) (IT)
(74) Vertreter: Patentanwälte Leinweber & Zimmermann

(57) **Zusammenfassung**

Die Erfindung betrifft eine Türstation einer Hauskommunikationsanlage, mit mindestens einer Funktionseinheit (18), die an einem Träger (10) zwischen mindestens zwei unterschiedlichen Stellungen verschwenkbar gehalten ist, nämlich einer Betriebsstellung und einer Einrichtstellung.

Erfindungsgemäß ist mindestens ein Anschlag (54) vorgesehen, der einem Verschwenken der Funktionseinheit (18) von der Einrichtstellung in die Betriebsstellung entgegenwirkt.

## Beschreibung

Die Erfindung betrifft eine Türstation einer Hauskommunikationsanlage, mit mindestens einer Funktionseinheit, die an einem Träger zwischen mindestens zwei unterschiedlichen Stellungen verschwenkbar gehalten ist, nämlich einer Betriebsstellung und einer Einrichtstellung.

Dabei wird unter einer Hauskommunikationsanlage eine Anlage verstanden, die üblicherweise die genannte Türstation sowie mindestens eine Wohnungsstation umfaßt. Zwischen den beiden Stationen ist in der Regel eine Kommunikation über Sprache und/oder Bild möglich. Darüber hinaus ist üblicherweise an der Türstation eine Einrichtung zum Auslösen eines Rufes in der Wohnungsstation (Klingeltaste) vorgesehen.

Der Träger dient in der Regel zur Wandbefestigung.

Türstationen der eingangs genannten Art sind bekannt, beispielsweise aus der DE-A-197 20 727. Bei der bekannten Türstation ist zwar die Funktionseinheit in der Einrichtstellung von allen Seiten zugänglich, was eine gewisse Erleichterung beim Einrichten bedeutet. Allerdings bedarf es zweier Hände, um beispielsweise eine Klemmschraube zum Einklemmen eines Drahtes für Kommunikationssignale anzuziehen.

Der Erfindung liegt daher die Aufgabe zugrunde, die Türstation der eingangs genannten Art derart weiterzubilden, daß das Einrichten vereinfacht ist.

Erfindungsgemäß wird die gestellte Aufgabe gelöst durch einen ersten Anschlag, der einem Verschwenken der Funktionseinrichtung von der Einrichtstellung in die Betriebsstellung entgegenwirkt.

Dieser erste Anschlag kann zum unterstützenden Halten der Funktionseinheit während des Einrichtens genutzt werden. So kann er beispielsweise als Widerlager beim Anziehen der oben erwähnten Klemmschraube dienen, wodurch das Anziehen der Schraube mit nur einer Hand möglich ist, während die andere Hand frei ist, um beispielsweise den anzuschließenden Draht in Position zu halten.

Nach der Erfindung ist dabei bevorzugt ein zweiter Anschlag vorgesehen, der einem Verschwenken der Funktionseinheit aus der Einrichtstellung im Sinne weg von der Betriebsstellung entgegenwirkt. Bei dieser Ausgestaltung ist die Funktionseinheit mithin gegen jegliches Verschwenken gesichert, solange die beiden Anschläge wirksam sind, wodurch das Einrichten der Funktionseinheit weiter vereinfacht ist.

Erfindungsgemäß bevorzugt ist ein elastisch verformbares Element zum In- und Außereingriffbringen des ersten und/oder des zweiten Anschlags vorgesehen. Bei dieser Ausgestaltung können die Anschläge quasi ein- und ausgeschaltet werden, wobei insbesondere das Ausschalten ein Verbringen der Funktionseinheit von der Einrichtstellung in die Betriebsstellung ermöglicht.

Das elastische Element ist erfindungsgemäß bevorzugt an der Funktionseinheit angeordnet. Diese Ausgestaltung ist insbesondere im Hinblick darauf von Vorteil, daß das elastische Element bedingt durch Materialermüdung brechen kann. In einem solchen Fall muß nur das Funktionselement und nicht der Träger ausgetauscht werden, was den Aufwand in einem solchen Reparaturfall erheblich vermindert.

Zur Reduktion der Teilezahl ist erfindungsgemäß bevorzugt das elastische Element einstückig mit der Funktionseinheit ausgebildet.

Die Schwenkachse der Funktionseinheit liegt in eingebautem Zustand senkrecht. Dadurch wird erreicht, daß die Schwerkraft keinen Einfluß auf den Verschwenkwinkel nimmt.

Zur Reduzierung der Teilezahl kann es erfindungsgemäß vorgesehen sein, daß die Schwenkachse einstückig mit der Funktionseinheit oder mit dem Träger ausgeführt ist. Aus dem gleichen Grunde kann vorgesehen sein, daß eine Lasche zum Aufnehmen der Schwenkachse einstückig mit dem Träger oder der Funktionseinheit ausgeführt ist.

Neben der oben beschriebenen Türstation schafft die Erfindung auch eine Türstation einer Hauskommunikationsanlage, mit mindestens zwei Funktionseinheiten, bei der alternativ oder zusätzlich zu den oben beschriebenen Merkmalen vorgesehen ist, daß die Funktionseinheiten sowohl mit einem gemeinsamen Bus als auch jeweils einzeln mit mindestens einer weiteren Einrichtung der Hauskommunikationsanlage zum Übertragen von Nutzsignalen verschaltet sind.

Dabei wird unter einem Nutzsignal nicht etwa eine Stromversorgung verstanden. Vielmehr sind Nutzsignale im Sinne der Erfindung nur Daten-, Informations- und Befehlssignale. Beispiele für solche Signale sind Sprachsignale, Bildsignale, Signale, die von Sensoren erzeugt werden, und Stellsignale.

Während herkömmliche Hauskommunikationsanlagen entweder nach dem Prinzip der Sternschaltung ausgelegt sind oder auf der Basis der Bustechnologie arbeiten, ist nach der Erfindung eine Kombination der beiden Prinzipien vorgesehen. So können beispielsweise Signale zum Einschalten von Licht in Abhängigkeit von den Signalen eines Dämmerungssensors der Türstation über einen Bus zugeführt werden, weil dieses Signal auch für andere Türstationen der Hauskommunikationsanlage vorgesehen ist, während das Auslösen eines Rufes an der Türstation aus Gründen der Abhörsicherheit über Leitungen weitergegeben wird, die nach Art der Sternschaltung verschaltet sind.

Darüber hinaus schafft die Erfindung eine Türstation einer Hauskommunikationsanlage, mit mindestens zwei Funktionseinheiten, bei der zusätzlich oder alternativ zu den oben beschriebenen Merkmalen die Funktionseinheiten mit einem gemeinsamen Bus verschaltet sind.

Zur Reduzierung der Teilezahl ist dabei erfindungsgemäß eine Verbindungseinrichtung vorgesehen, die sowohl zum elektrischen als auch zum mechanischen Verbinden zweier Funktionseinheiten miteinander dient.

Die Funktionseinheiten können dabei erfindungsgemäß bevorzugt mindestens eine Buchse aufweisen, die derart angeordnet ist, daß Buchsen benachbarter Funktionseinheiten in eingebautem Zustand parallel zueinander liegen, wobei die Verbindungseinrichtung mindestens zwei Stifte aufweist, die in die Buchsen passen.

Bei dieser Ausgestaltung wirkt eine Kraft, die die beiden Funktionseinheiten voneinander entfernt, quer zur Längserstreckung der beiden Stifte und damit in einer Richtung, in der die beiden Stifte einer solchen Kraft besonders viel Widerstand entgegensetzen, wodurch eine hohe mechanische Stabilität gegeben ist.

Erfindungsgemäß bevorzugt ist ein Kabelkanal vorgesehen, der zum Aufnehmen insbesondere von Kabeln dient, die zur Realisierung der oben erwähnten Sternschaltung eingesetzt werden.

Die Erfindung schafft ferner eine Türstation einer Hauskommunikationsanlage, die die oben erwähnten Merkmale aufweisen kann, aber nicht muß, mit mindestens einer Funktionseinheit und einem Rahmen zum Halten der Funktionseinheit.

Dabei ist erfindungsgemäß vorgesehen, daß die Funktionseinheit eine separate Frontabdeckung aufweist und der Rahmen dazu dient, die Frontabdeckung auf der Funktionseinheit zu halten.

Das Vorsehen der separaten Frontabdeckung hat insbesondere den Vorteil, daß die Frontabdeckung dadurch austauschbar ist, wodurch der Türstation ein jeweils den gegebenen Begleitumständen angepaßtes Aussehen verliehen werden kann. Da der Rahmen zum Halten der Frontabdeckung auf der Funktionseinheit genutzt wird, sind keine zusätzlichen Maßnahmen zum Anbringen der Frontabdeckung erforderlich.

Zur Minimierung des Aufwands zum Halten der Frontabdeckung ist erfindungsgemäß bevorzugt vorgesehen, daß die Frontabdeckung in montiertem Zustand zwischen dem Rahmen und der Funktionseinheit gehalten ist. Sie wird mithin einfach zwischen dem Rahmen und der Funktionseinheit eingeklemmt. Dadurch sind keine weiteren Maßnahmen zum Halten der Frontabdeckung erforderlich.

Neben der oben beschriebenen Türstation schafft die Erfindung auch eine Funktionseinheit einer solchen Türstation, wobei die Funktionseinheit erfindungsgemäß einzelne für die Verwirklichung der oben beschriebenen Türstation erforderliche Merkmale haben kann, aber nicht muß.

Erfindungsgemäß bevorzugt ist bei der Funktionseinheit ein elastisch verformbares Element vorgesehen, und zwar zum In- und Außereingriffbringen mindestens eines einem Verschwenken entgegenwirkenden Anschlags.

Dabei kann eine Schwenkachse oder eine Lasche zum Aufnehmen einer Schwenkachse an der erfindungsgemäßen Funktionseinheit vorgesehen sein.

Zur Verwirklichung der oben im einzelnen beschriebenen "dualen Verschaltung" der Hauskommunikationsanlage kann bei der erfindungsgemäßen Funktionseinheit ein Busanschluß sowie ein Anschluß zum separaten Verschalten mit mindestens einer weiteren Einrichtung der Hauskommunikationsanlage vorgesehen sein.

Ein Busanschluß kann in Form mindestens einer Buchse ausgeführt sein. Dadurch besteht insbesondere die Möglichkeit, den Busanschluß nicht nur zum elektrischen Verschalten, sondern auch zum mechanischen Verbinden mit einer benachbarten Funktionseinheit oder einem anderen Element der Türstation zu nutzen.

Erfindungsgemäß kann eine separate Frontabdeckung an der Funktionseinheit vorgesehen sein. Dadurch besteht die Möglichkeit der Anpassung der Funktionseinheit an die gegebenen Begleitumstände.

Die Funktionseinheit kann erfindungsgemäß bevorzugt eine eigene Schutzeinrichtung gegen das Eindringen von Wasser haben. Dadurch entfällt das Erfordernis, die gesamte Türstation gegen das Eindringen von Wasser zu sichern.

Zur Vereinfachung der Arbeiten zum Einrichten der Funktionseinheit bzw. der Türstation oder der Hauskommunikationsanlage, an die die Funktionseinheit anzuschließen ist, ist es erfindungsgemäß bevorzugt vorgesehen, daß Justiereinrichtungen und/oder Prüfeinrichtungen von der Frontseite her zugänglich sind. Bei dieser Ausgestaltung bedarf es mithin noch nicht einmal eines Verschwenkens der Funktionseinheit von der Betriebsstellung in die Einrichtstellung, um Justier- und Prüfarbeiten auszuführen.

Die erfindungsgemäße Funktionseinheit kann einen Lautsprecher sowie eine Einrichtung zum Einbauen eines Mikrophons aufweisen. Sie kann aber auch eine sich von einem Lautsprecher unterscheidende Funktion haben und eine Einrichtung zum Einbau eines Mikrophons aufweisen.

Bevorzugt werden zwei Funktionseinheiten der oben beschriebenen Arten miteinander kombiniert. Dabei wird man zunächst ein Mikrophon in die Funktionseinheit mit dem Lautsprecher einbauen. Ergeben jedoch die Gesamtumstände, daß Rückkopplungen auftreten, so kann das Mikrophon auf einfache Weise aus der Funktionseinheit mit dem Lautsprecher in die Funktionseinheit mit der sich von einem Lautsprecher unterscheidenden Funktion versetzt werden, wodurch der Abstand zu dem Lautsprecher vergrößert ist. Dadurch ist die Gefahr von Rückkopplungen in der Regel gebannt. Bei der Funktionseinheit mit der sich von einem Lautsprecher unterscheidenden Funktion handelt es sich bevorzugt um eine Funktionseinheit mit einer Kamera, weil eine solche Funktionseinheit häufig in etwa in Kopfhöhe an einer Türstation angebracht wird, so daß das Mikrophon für die Aufnahme von Sprachsignalen optimal angeordnet ist.

Bevorzugt weist die Einrichtung zum Einbau eines Mikrophons eine Buchse und/oder einen Stecker auf, die bzw. der sowohl zum mechanischen Halten als auch zum elektrischen Verbinden eines Mikrophons dient/dienen.

Dadurch wird das Versetzen eines Mikrophons von der einen in die andere Funktionseinheit besonders einfach (plug and play).

Die Funktionseinheit kann schließlich erfindungsgemäß bevorzugt eine Kamera aufweisen, die verschwenkbar gehalten und in mindestens einer Verschwenkstellung mittels einer Schraube fixierbar ist.

Bei dieser Ausgestaltung der erfindungsgemäßen Funktionseinheit kann auf besonders einfache Weise die Kamera entsprechend den Einbaugegebenheiten eingerichtet werden.

Im folgenden ist die Erfindung anhand eines bevorzugten Ausführungsbeispiels unter Bezugnahme auf die beiliegende Zeichnung mit weiteren Einzelheiten näher erläutert. Dabei zeigen
- Figur 1: eine schematische perspektivische Explosionsdarstellung einer Türstation nach einem bevorzugten Ausführungsbeispiel der Erfindung,
- Figur 2: eine schematische perspektivische Explosionsdarstellung einer Funktionseinheit der Türstation nach Figur 1, mit Montagezubehör,
- Figur 3: schematisch eine Funktionseinheit in zwei unterschiedlichen Montagestellungen und
- Figur 4: eine weitere schematische perspektivische Ansicht einer Funktionseinheit mit Montagezubehör.

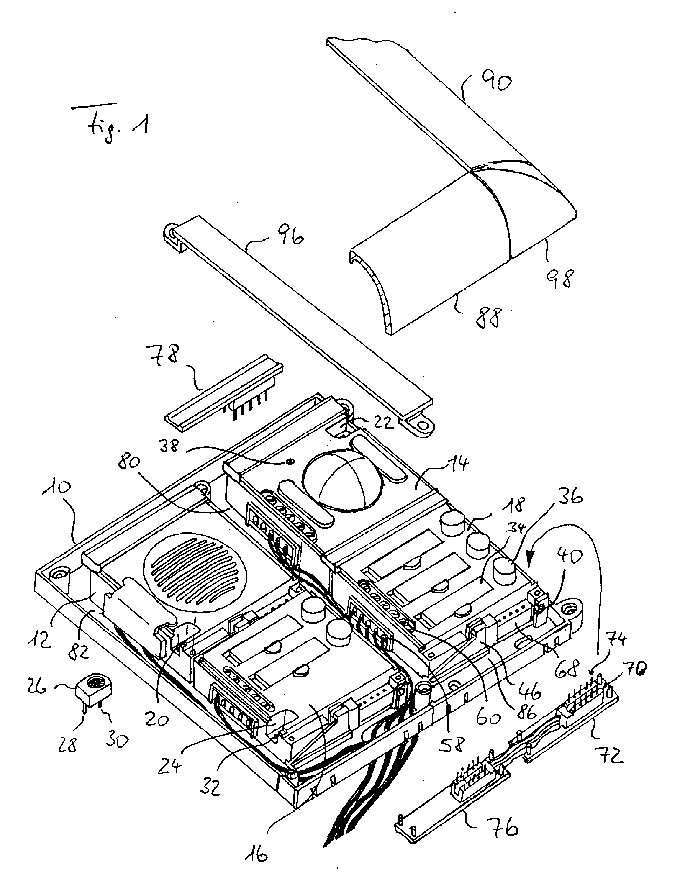

Die in der Zeichnung dargestellte Türstation hat eine Basis 10, die zur Aufputzmontage an einer Wand ausgelegt ist. In Figur 1 sind vier Funktionseinheiten dargestellt, nämlich eine Lautsprechereinheit 12, eine Kameraeinheit 14 und zwei Ruftasteneinheiten 16 und 18. An der Lautsprechereinheit 12, der Kameraeinheit 14 und der Ruftasteneinheit 16 ist jeweils eine Aussparung 20, 22 bzw. 24 vorgesehen, in die ein Mikrophon 26 paßt. Zur Montage des Mikrophons 26 sowohl in mechanischer als auch in elektrischer Hinsicht dienen Stecker 28, 30, die in Buchsen passen, von denen beispielhaft zwei mit dem Bezugszeichen 32 bezeichnet sind. An den Ruftasteneinheiten sind jeweils Namensschilder und Ruftasten angebracht. Beispiele sind mit den Bezugszahlen 34 bzw. 36 bezeichnet.

Mit der Bezugszahl 38 ist eine Klemmschraube an der Kameraeinheit 14 bezeichnet. Zum Einstellen des Blickwinkels der (nicht gezeigten) Kamera wird die Klemmschraube 38 gelöst. Nach dem Einstellen des Blickwinkels wird sie wieder angezogen.

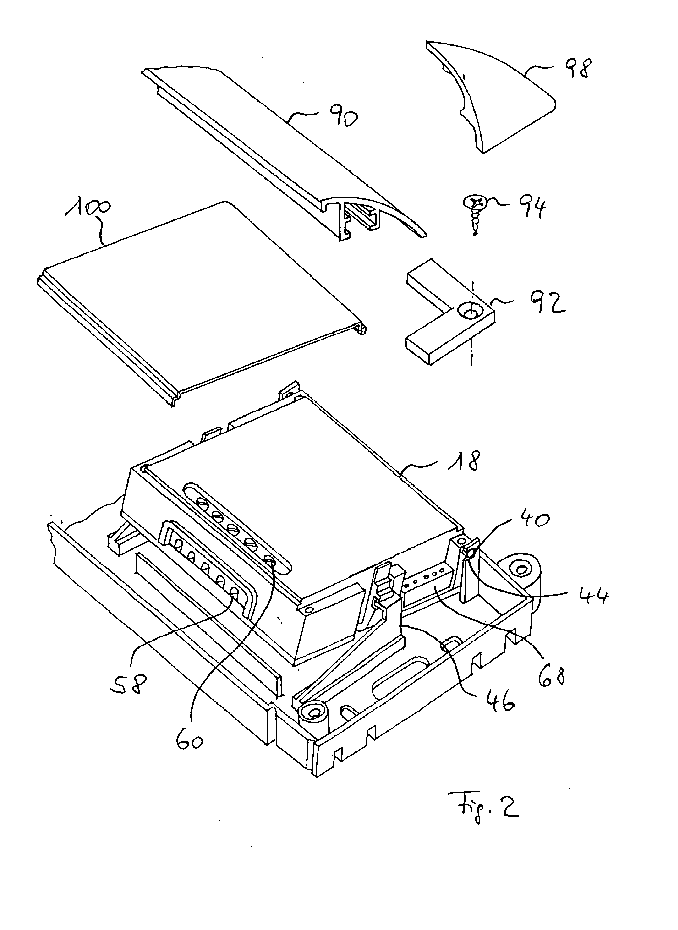

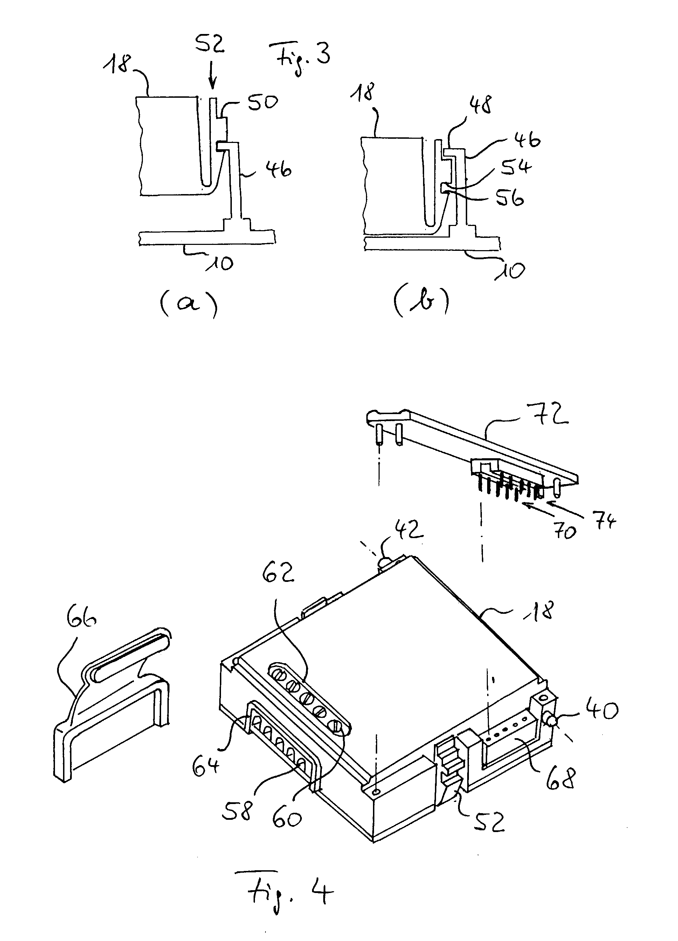

Zur Befestigung der Funktionseinheiten 12, 14, 16 und 18 dienen zum einen Achsen 40 und 42, die in entsprechende Laschen eingeschoben werden. Eine solche Lasche ist beispielhaft in Figur 2 mit dem Bezugszeichen 44 versehen. Zum anderen dient zur Befestigung der Funktionseinheiten eine Rastmechanik, die mit einigen Einzelheiten in Figur 3 dargestellt ist. Zu der Rastmechanik gehört ein Ansatz 46, der einstückig mit der Basis 10 ausgeführt ist. In der Betriebsstellung der jeweiligen in den Figuren 2 und 4 universell dargestellten Funktionseinheit, vgl. Fig. 3b, übergreift der Ansatz 46 mit einer Nase 48 einen Anschlag 50 an einem Rastansatz 52 der Funktionseinheit 18. Der Rastansatz 52 ist federnd ausgebildet. Er kann nämlich in Figur 3 nach links ausgelenkt werden. Geschieht dies, so gibt der Ansatz 46 den Anschlag 50 frei und die Funktionseinheit 18 kann um die Achsen 40, 42 herum verschwenkt werden, beispielsweise in die in den Figuren 2 und 3a gezeigte sogenannte Einrichtstellung. In dieser Stellung dienen zwei Anschläge 54 und 56 (vgl. Figur 3b) einer Arretierung, und zwar in Zusammenarbeit mit der Nase 48. In dieser Einrichtstellung ist die Funktionseinheit 18 nach oben verkippt, wodurch Kabeleinlässe leicht erreichbar sind. Ein solcher Kabeleinlaß ist beispielhaft mit der Bezugszahl 58 bezeichnet. Eine zu dem Kabeleinlaß 58 zugehörige Klemmschraube ist mit der Bezugszahl 60 bezeichnet. Die Klemmschraube 60 ist über einen fensterartigen Ausschnitt 62 von der Frontseite der Funktionseinheit 18 zugänglich. In gleicher Weise liegt der Kabeleinlaß 58 in einem fensterartigen Ausschnitt 64. Zur Abdichtung der fensterartigen Ausschnitte 62 und 64 dient ein Dichtelement 66. Nach Anbringen des Dichtelements 66 ist die Funktionseinheit komplett gegen das Eindringen von Wasser abgesichert, weshalb es nicht erforderlich ist, die Basis 10 wasserdicht auszugestalten.

Wie insbesondere Figur 4 zu entnehmen ist, weisen die Funktionseinheiten jeweils eine Buchse 68 auf, in die eine Beinreihe 70 eines Steckers 72 paßt. An dem Stecker 72 ist noch eine weitere Beinreihe 74 ausgebildet. Wenngleich dies in der Zeichnung nicht im einzelnen dargestellt ist, so kann der Stecker 72 beispielsweise mit seiner Beinreihe 70 in eine entsprechende Buchse an der Kameraeinheit 14 und mit seiner Beinreihe 74 in eine entsprechende Buchse an der Ruftasteneinheit 18 eingesteckt werden. Da die Beinreihen 70 und 74 jeweils beinpaarweise miteinander kurzgeschlossen sind, ergibt sich dadurch in elektrischer Hinsicht eine busartige Verschalung der beiden Funktionseinheiten 14 und 18 miteinander. Gleichzeitig dient der Stecker 72 zur mechanischen Kopplung der beiden Funktionseinheiten 14 und 18.

Figur 1 zeigt noch darüber hinaus, daß zwei gleichartige Stecker 72 und 76 derart miteinander verschaltet werden können, daß bei einem Anschluß an die Funktionseinheiten 16 und 18 auch dann eine busartige Verschaltung möglich ist, wenn die jeweiligen Buchsen nicht unmittelbar nebeneinander liegen. Ein weiterer Stecker ist in Figur 1 noch mit der Bezugszahl 78 bezeichnet.

In der Basis 10 sind Kabelkanäle ausgebildet, von denen einige beispielhaft mit den Bezugszahlen 80, 82, 84 und 86 bezeichnet sind. Zur Abdeckung dieser Kabelkanäle dienen Rahmenstege 88 und 90, die über einen Eckverbinder 92 mittels einer Schraube 94 an der Basis 10 befestigt werden, sowie eine Sprosse 96, die in dem gezeigten Ausführungsbeispiel zum Abdecken des Kabelkanals 80 bzw. zum Teilen des Rahmens in zwei Hälften dient. Über dem Eckverbinder 92 liegt eine Zierkappe 98.

Wie insbesondere Figur 2 zu entnehmen ist, hält der Rahmensteg 90 eine Frontabdeckung 100 auf der Funktionseinheit 18. Die Frontabdeckung 100 ist in Figur 2 als Rohling dargestellt. Sie ist selbstverständlich jeweils entsprechend der von ihr abgedeckten Funktionseinheit gestaltet. So hat sie im Falle der Ruftasteneinheit 18 beispielsweise Aussparungen für die Ruftaste 36 und das Namensschild 34. Der Vorteil dieser separaten Frontabdeckung 100 liegt in der Flexibilität der Gestaltung des äußeren Erscheinungsbildes der Funktionseinheit bzw. der Türstation. Die Frontabdeckung 100 braucht keinerlei zusätzliche Befestigungseinrichtungen, weil sie einfach zwischen dem Rahmensteg 90 und der Funktionseinheit 18 eingeklemmt wird.

Die in der obigen Beschreibung, den Ansprüchen sowie der Zeichnung offenbarten Merkmale der Erfindung können sowohl einzeln als auch in beliebigen Kombinationen für die Verwirklichung der Erfindung in ihren verschiedenen Ausführungsformen wesentlich sein.

## Patentansprüche

1. Türstation einer Hauskommunikationsanlage, mit mindestens einer Funktionseinheit (18), die an einem Träger (10) zwischen mindestens zwei unterschiedlichen Stellungen verschwenkbar gehalten ist, nämlich einer Betriebsstellung und einer Einrichtstellung,
**gekennzeichnet durch**
einen ersten Anschlag (54), der einem Verschwenken der Funktionseinheit (18) von der Einrichtstellung in die Betriebsstellung entgegenwirkt.

2. Türstation nach Anspruch 1, **gekennzeichnet durch** einen zweiten Anschlag (56), der einem Verschwenken der Funktionseinheit (18) aus der Einrichtstellung im Sinne weg von der Betriebsstellung entgegenwirkt.

3. Türstation nach Anspruch 1 oder 2, **gekennzeichnet durch** ein elastisch verformbares Element (52) zum In- und Außereingriffbringen des ersten und/oder des zweiten Anschlages (54, 56).

4. Türstation nach Anspruch 3, **dadurch gekennzeichnet, daß** das elastische Element (52) an der Funktionseinheit (18) angeordnet ist.

5. Türstation nach Anspruch 4, **dadurch gekennzeichnet, daß** das elastische Element (52) einstückig mit der Funktionseinheit (18) ausgebildet ist.

6. Türstation nach einem der vorangehenden Ansprüche, **dadurch gekennzeichnet, daß** die Schwenkachse (40, 42) der Funktionseinheit (18) in eingebautem Zustand senkrecht liegt.

7. Türstation nach einem der vorangehenden Ansprüche, **dadurch gekennzeichnet, daß** die Schwenkachse (40, 42) einstückig mit der Funktionseinheit (18) oder mit dem Träger (10) ausgeführt ist.

8. Türstation nach einem der vorangehenden Ansprüche, **dadurch gekennzeichnet, daß** eine Lasche (44) zum Aufnehmen der Schwenkachse (40, 42) einstückig mit dem Träger (10) oder der Funktionseinheit (18) ausgeführt ist.

9. Türstation einer Hauskommunikationsanlage, mit mindestens zwei Funktionseinheiten (14, 18), insbesondere nach einem der vorangehenden Ansprüche,
**dadurch gekennzeichnet, daß**
die Funktionseinheiten (14, 18) sowohl mit einem gemeinsamen Bus als auch jeweils einzeln mit mindestens einer weiteren Einrichtung der Hauskommunikationsanlage zum Übertragen von Nutzsignalen verschaltet sind.

10. Türstation einer Hauskommunikationsanlage, mit mindestens zwei Funktionseinheiten (14, 18), insbesondere nach einem der vorangehenden Ansprüche, wobei die Funktionseinheiten (14, 18) mit einem gemeinsamen Bus verschaltet sind,
**gekennzeichnet durch**
eine Verbindungseinrichtung (72), die sowohl zum elektrischen als auch zum mechanischen Verbinden zweier Funktionseinheiten (14, 18) miteinander dient.

11. Türstation nach Anspruch 10, **dadurch gekennzeichnet, daß** die Funktionseinheiten (14, 18) jeweils mindestens eine Buchse (68) aufweisen, die derart angeordnet ist, daß Buchsen (68) benachbarter Funktionseinheiten (14, 18) in eingebautem Zustand parallel zueinander liegen, und die Verbindungseinrichtung (72) mindestens zwei Stifte (70, 74) aufweist, die in die Buchsen (68) passen.

12. Türstation nach einem der Ansprüche 9 bis 11, **gekennzeichnet durch** einen Kabelkanal (80, 82, 84, 86).

13. Türstation einer Hauskommunikationsanlage, insbesondere nach einem der vorangehenden Ansprüche, mit mindestens einer Funktionseinheit (18) und einem Rahmen (88, 90) zum Halten der Funktionseinheit (18),
**dadurch gekennzeichnet, daß** die Funktionseinheit (18) eine separate Frontabdekkung (100) aufweist und der Rahmen (88, 90) dazu dient, die Frontabdeckung (100) auf der Funktionseinheit (18) zu halten.

14. Türstation nach Anspruch 13, **dadurch gekennzeichnet, daß** die Frontabdeckung (100) in montiertem Zustand zwischen dem Rahmen (88, 90) und der Funktionseinheit (18) gehalten ist.

15. Funktionseinheit einer Türstation einer Hauskommunikationsanlage, insbesondere einer Türstation nach einem der vorangehenden Ansprüche.

16. Funktionseinheit nach Anspruch 15, **gekennzeichnet durch** ein elastisch verformbares Element (52) zum In- und Außereingriffbringen mindestens eines einem Verschwenken entgegenwirkenden Anschlags (50, 54, 56).

17. Funktionseinheit nach Anspruch 15 oder 16, **gekennzeichnet durch** eine Schwenkachse (40, 42) oder eine Lasche zum Aufnehmen einer Schwenkachse.

18. Funktionseinheit nach einem der Ansprüche 15 bis 17, **gekennzeichnet durch** einen Busanschluß (68) sowie einen Anschluß (58) zum separaten Verschalten mit mindestens einer weiteren Einrichtung der Hauskommunikationsanlage.

19. Funktionseinheit nach einem der Ansprüche 15 bis 18, **gekennzeichnet durch** einen Busanschluß in Form mindestens einer Buchse (68).

20. Funktionseinheit nach einem der Ansprüche 15 bis 19, **gekennzeichnet durch** eine separate Frontabdeckung (100).

21. Funktionseinheit nach einem der Ansprüche 15 bis 20, **dadurch gekennzeichnet, daß** sie eine eigene Schutzeinrichtung (66) gegen das Eindringen von Wasser hat.

22. Funktionseinheit nach einem der Ansprüche 15 bis 21, **dadurch gekennzeichnet, daß** Justiereinrichtungen und/oder Prüfeinrichtungen (60) von der Frontseite her zugänglich sind.

23. Funktionseinheit (12) nach einem der Ansprüche 15 bis 22, **dadurch gekennzeichnet, daß** sie einen Lautsprecher sowie eine Einrichtung (20) zum Einbau eines Mikrophons (26) aufweist.

24. Funktionseinheit (14, 16), **dadurch gekennzeichnet, daß** sie eine sich von einem Lautsprecher unterscheidende Funktion hat und eine Einrichtung (22, 24) zum Einbau eines Mikrophons (26) aufweist.

25. Funktionseinheit (12, 14, 16), **dadurch gekennzeichnet, daß** die Einrichtung (20, 22, 24) zum Einbau eines Mikrophons (26) eine Buchse (32) und/oder einen Stecker aufweist, die bzw. der sowohl zum mechanischen Halten als auch zum elektrischen Verbinden eines Mikrophons (26) dient/dienen.

26. Funktionseinheit (14) nach einem der Ansprüche 15 bis 25, **dadurch gekennzeichnet, daß** sie eine Kamera aufweist, die verschwenkbar gehalten und in mindestens einer Verschwenkstellung mittels einer Schraube (38) fixierbar ist.
